# EUROPEAN PATENT APPLICATION

(11) **EP 2 367 017 A2**
(43) Date of publication of application: **21.09.2011**
(21) Application number: 11151231.5
(22) Date of filing: 18.01.2011
(51) Int. Cl.: G01R 31/02, G01R 31/42

(54) **Method for detecting capacity leakage of capacitor in power conditioner, power conditioner performing the same, and photovoltaic power system provided with the same**

(30) Priority: 11.03.2010 JP 2010054247
(71) Applicant: Omron Co., Ltd., Kyoto-shi, Kyoto 600-8530 (JP)
(72) Inventor: Miyamoto, Mio, Kyoto-shi, Kyoto 600-8530 (JP); Mabuchi, Masao, Kyoto-shi, Kyoto 600-8530 (JP); Nakamura, Kotaro, Kyoto-shi, Kyoto 600-8530 (JP)
(74) Representative: Wilhelms · Kilian & Partner Patentanwälte

(57) **Abstract**

A capacity leakage of a capacitor (18, 19) in a power conditioner (3) of a photovoltaic power system is detected to continue or stop running of the system according to a degree of the capacity leakage. A method according to an embodiment of the invention for detecting the capacity leakage of the capacitor is a method for detecting the capacity leakage of the capacitor in the power conditioner (3) that performs power conversion of an output of a photovoltaic cell (1) to output an output power to the system side. The method for detecting the capacity leakage of the capacitor includes the steps of: detecting that the capacity leakage exists based on a voltage deviation of a charge voltage between both ends of the capacitor of a detection target of the capacity leakage; suppressing the output power when the detected capacity leakage is a capacity leakage in which the running can be continued by the output power suppression: and stopping the running of the photovoltaic power system provided with the power conditioner when the capacity leakage is a capacity leakage in which the running of the system cannot be continued even if the output power is suppressed,

## Description

### BACKGROUND OF THE INVENTION

### 1. TECHNICAL FIELD

The present invention relates to a method for detecting a capacity leakage of a capacitor in a power conditioner of an inverter, a converter, and the like, a power conditioner performing the method, and a photovoltaic power system provided with the power conditioner.

### 2. RELATED ART

In the power conditioner used in the photovoltaic power system, there have been proposed many methods for detecting a capacity leakage of a capacitor, because a capacitor is particularly easily deteriorated due to the capacity leakage in various components constituting the power conditioner (for example, see Japanese Unexamined Patent Publication Nos. 2006-333661 and 2007-252057).

### SUMMARY

In the power conditioner, when a power conversion operation is continued while the capacity leakage is generated, the power is inconveniently supplied to a system side or a load side from the system of the power conditioner. In such cases, conventionally running of the system is stopped to change the capacitor in which the capacity leakage is generated.

The present invention provides a novel method for detecting a capacity leakage of a capacitor in a power conditioner, particularly a method for detecting a capacity leakage of a capacitor, in which running of a system can be continued or stopped according to a degree of the capacity leakage of the capacitor when the capacity leakage is generated in a photovoltaic power system diseased in Japanese Patent Application No. 2009-61915 filed by the inventor.

In accordance with one aspect of the present invention, there is provided a method for detecting a capacity leakage of at least one of a second capacitor and a third capacitor in a power conditioner that performs power conversion of an output of a photovoltaic cell to output an output power to a system side, the power conditioner including a first capacitor that is connected in parallel to the photovoltaic cell; a first chopper circuit that includes at least first and second switch elements connected in series, the first and second switch elements being connected in parallel to the first capacitor; a second chopper circuit that includes the second capacitor and at least third and fourth switch elements, connected in series, the second capacitor being connected in parallel to the third and fourth switch elements, one end side of the parallel connection being connected to a common connection portion of the first and second switch elements; and a third chopper circuit that includes at least fifth and sixth switch elements connected in series, the third capacitor, and seventh and eighth switch elements connected in series, the fifth and sixth switch elements, the third capacitor, and the seventh and eighth switch elements being connected in parallel, one end side of the parallel connection of the fifth and sixth switch elements being connected to a common connection portion of the third and fourth switch elements, the method including the steps of: detecting that the capacity leakage exists based on a voltage deviation of a charge voltage between both ends of the capacitor of a detection target of the capacity leakage; and suppressing the output power when the detected capacity leakage is a capacity leakage in which running can be continued by suppression of the output power.

Preferably the method in accordance with the aspect of the present invention further includes the step of stopping the running when the capacity leakage is a capacity leakage in which the running cannot be continued even if the output power is suppressed.

According to the present invention, the capacity leakage of the second capacitor or third capacitor is detected, and the running can be continued by suppressing the output power in the capacity leakage to an extent in which the running of the system can be continued even if the capacity leakage is detected, which allows extension of a lifetime. On the other hand, the running of the system is stopped when the capacity leakage is generated to an extent in which the running of the system cannot be continued. Therefore, the system having the excellent user-friendliness can be provided.

### BRIEF DESCRIPTION OF THE DRAWINGS

Fig. 1 is a configuration diagram illustrating a photovoltaic power system to which a capacitor capacity leakage detecting method according to an embodiment of the present invention is applied;
Figs. 2A to 2D are views for explaining an operation of a power conditioner in the photovoltaic power system of Fig. 1;
Figs. 3A and 3B are views for explaining an operation principle of a first chopper circuit of Fig. 1;
Figs. 4A to 4D are views for explaining an operation principle of a second chopper circuit of Fig. 1;
Fig. 5 is a view for explaining an operation principle of a third chopper circuit of Fig. 1;
Figs. 6A and 6B are views illustrating a voltage waveform of each unit of Fig. 5;
Figs. 7A to 7F are timing charts illustrating an operation waveform of each unit during a normal operation;
Figs. 8A to 8D, 8G, and 8H are timing charts illustrating an operation waveform of each unit during a capacity leakage of a capacitor;
Figs. 9A, 9B, 9E, 9F, 9G, and 9H are timing charts illustrating an operation waveform of each unit during a capacity leakage of another capacitor;
Fig. 10 is a flowchart illustrating an operation of each unit;
Fig. 11 is a view illustrating a relationship between an output power and a capacitor voltage ripple;
Fig. 12 is a view illustrating a one-day output variation of a photovoltaic cell;
Fig. 13 is a timing chart illustrating a rated output during the normal operation;
Fig. 14 is a timing chart illustrating a rated output during the capacity leakage of the capacitor; and
Fig. 15 is a timing chart illustrating waveforms during output suppression.

### DETAILED DESCRIPTION

A photovoltaic power system to which a capacitor capacity leakage detecting method according to an embodiment of the present invention is applied will be described below with reference to the drawings.

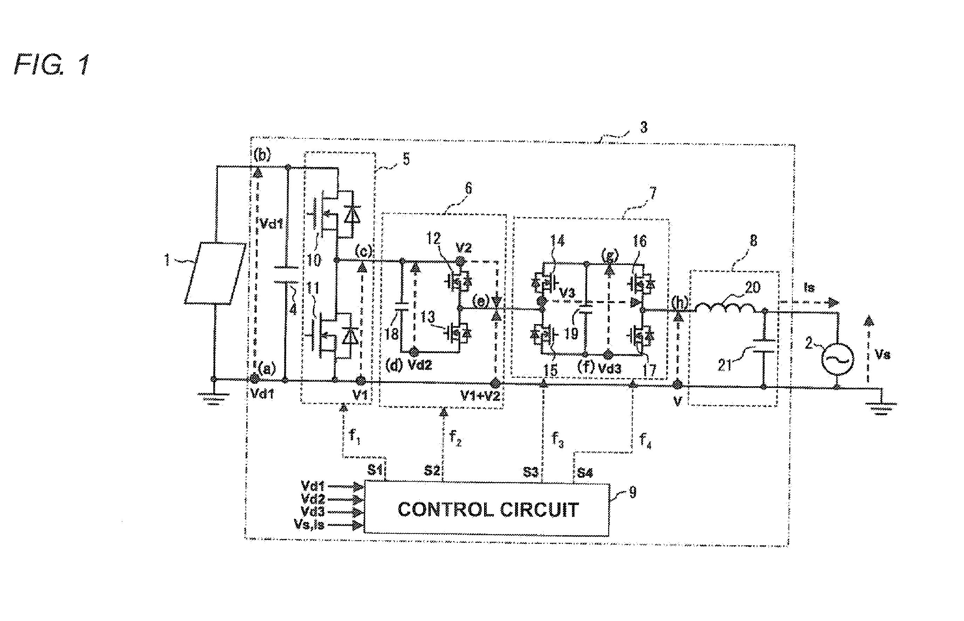

Fig. 1 is a configuration diagram of a photovoltaic power system according to an embodiment of the present invention, and Fig. 1 illustrates a configuration of a single-phase two-wire system.

The photovoltaic power system of the embodiment includes a photovoltaic panel 1 and a power conditioner 3. The power conditioner 3 converts a DC power from the photovoltaic panel 1 into an AC power, and the power conditioner 3 is operated while being interconnected to a commercial power source 2.

The photovoltaic panel 1 is configured such that a plurality of photovoltaic modules are connected in series or parallel to obtain a required power.

The photovoltaic panel 1 of the embodiment incudes a thin-film photovoltaic cell made of amorphous silicon.

The power conditioner 3 of the embodiment is a non-insulating (transformer-less) power conditioner that is not provided with an insulating transformer.

The power conditioner 3 includes a first capacitor 4 serving as a smoothing capacitor, first to third chopper circuits 5 to 7, a noise filter 8, and a control circuit 9 that measures a voltage of each unit to control the chopper circuits 5 to 7.

The first to third chopper circuits 5 to 7 and the control circuit 9 constitute a chopper converter that is connected in a cascade manner to the photovoltaic panel 1.

A negative electrode side of the photovoltaic panel 1 is grounded. A point (a) illustrated in Fig. 1 is the ground, and the ground has a voltage of zero. A point (b) indicates a positive electrode side of the photovoltaic panel 1.

The first capacitor 4 is connected in parallel between the positive and negative electrodes of the photovoltaic panel 1.

The first chopper circuit 5 is connected in parallel to the first capacitor 4.

The first chopper circuit 5 includes first and second switch elements 10 and 11 that are connected in series. Diodes are connected in reversely parallel to the first and second switch elements 10 and 11, respectively. The first chopper circuit 5 constitutes a first switch circuit by the first and second switch elements 10 and 11.

In the first chopper circuit 5, the first and second switch elements 10 and 11 are alternately ON/OFF-controlled at a system frequency, for example, a first frequency f₁ of 50 Hz by a gate signal S1 from the control circuit 9. For example, the first and second switch elements 10 and 11 includes N-channel MOSFETs similarly to switch elements 12 to 17 of the second and third chopper circuits 6 and 7. The switch element may be other switch elements such as an IGBT and a transistor instead of the MOSFET.

The second chopper circuit 6 incudes a second capacitor 18 and a second switch circuit. In the second switch circuit, the third and fourth switch elements 12 and 13 that are connected in series, and each of the switch elements 12 and 13 includes two diodes that are connected in reversely parallel. The second capacitor 18 and the second switch circuit are connected in parallel. The third and fourth switch elements 12 and 13 are alternately ON/OFF-controlled at a second frequency f₂ by a gate signal S2 from the control circuit 9. For example, the second frequency f₂ is set to 100 Hz that is double the first frequency f₁. In the second chopper circuit 6, one end side of the parallel connection between the second capacitor 18 and the second switch circuit is connected to the series-connected portion between the first and second switch elements 10 and 11 of the first chopper circuit 5. The connection point is illustrated by a point (c) in Fig. 1. In Fig. 1, the points (c) and (d) correspond to both the capacitor electrode sides of the second capacitor 18.

The third chopper circuit 7 includes a third switch circuit, a third capacitor 19, and a fourth switch circuit, In the third switch circuit, the fifth and sixth switch elements 14 and 15 are connected in series, and each of the switch elements 14 and 15 includes two diodes that are connected in reversely parallel. In the fourth switch circuit, the seventh and eighth switch elements 16 and 17 are connected in series, and each of the switch elements 16 and 17 includes two diodes that are connected in reversely parallel. In the third chopper circuit 7, the third switch circuit, the third capacitor 19, and the fourth switch circuit are connected in parallel. One end side and the other end side of the parallel connection among the circuits are illustrated by points (f) and (g) in Fig. 1. The points (f) and (g) correspond to both the capacitor electrode sides of the third capacitor 19.

The fifth and sixth switch elements 14 and 15 are alternately ON/OFF-controlled at a third frequency f₃ by a gate signal S3 from the control circuit 9. For example, the third frequency f₃ is set to 150 Hz that is triple the first frequency f₁.

The seventh and eighth switch elements 16 and 17 are alternately PWM-controlled at a high frequency f₄ of, for example, 18 kHz by a gate signal S4 from the control circuit 9.

The series-connected portion between the fifth and sixth switch elements 14 and 15 of the third chopper circuit 7 is connected to the series-connected portion between the third and fourth switch elements 12 and 13 of the second chopper circuit 6. The connection point is illustrated by a point (e) in Fig. 1.

The noise filter 8 including a reactor 20 and a fourth capacitor 21 is connected to the series-connected portion between the seventh and eighth switch elements 16 and 17 of the third chopper circuit 7. The connection point is illustrated by a point (h) in Fig. 1.

A load (not illustrated) and the commercial power source 2 are connected to the noise filter 8.

The control circuit 9 measures a system voltage Vs and a system current is to compute a command value V* of a sine-wave target voltage synchronized with a system frequency of the commercial power source 2 as is conventionally done, and the control circuit 9 measures voltages Vd1, Vd2, and Vd3 at both ends of the first to third capacitors 4, 18, and 19 to produce the gate signals in order to control the chopper circuits 5 to 7.

The voltage Vd1 is a DC output voltage of the photovoltaic panel 1, which emerges at the point (b) based on the voltage at the point (a) that is the ground.

The voltage Vd2 is a charge voltage at the point (c) of one of the electrodes of the second capacitor 18 in the second chopper circuit 6 based on the point (d) of the other electrode of the second capacitors 18.

The voltage Vd3 is a charge voltage at the point (g) of one of the electrodes of the third capacitor 19 in the third chopper circuit 7 based on the point (f) of the other electrode of the third capacitor 19.

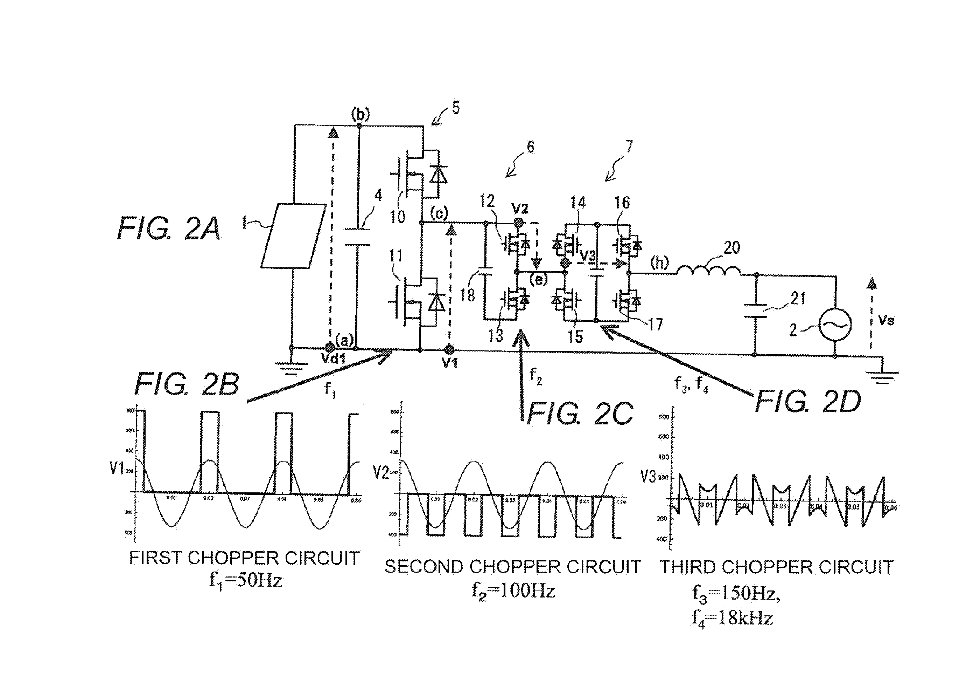

Figs. 2A to 2D are schematic diagrams for explaining an operation of each of the chopper circuits 5 to 7 of the embodiment, Fig. 2A illustrates a configuration of a main part of Fig. 1, and Figs. 2B to 2D illustrate voltages V1, V2, and V3 of Fig. 2A, respectively. In Figs. 2B and 2C, the waveform of the command value V* of the sine-wave target voltage synchronized with the system is illustrated by a thin solid line.

The voltage V1 is a voltage at the point (c) that is of the series-connected portion of the first and second switch elements 10 and 11 of the first chopper circuit 5 when a potential at the point (a) that is of the ground is set to a first reference potential.

The voltage V2 is a voltage at the point (e) that is of the series-connected portion of the third and fourth switch elements 12 and 13 of the second chopper circuit 6 when a potential at the point (c) is set to a second reference potential.

The voltage V3 is a voltage at the point (h) that is of the series-connected portion of the seventh and eighth switch elements 16 and 17 based on the point (e) that is of the series-connected portion of the fifth and sixth switch elements 14 and 15 of the third chopper circuit 7.

In the first chopper circuit 5, the first and second switch elements 10 and 11 are alternately ON/OFF-controlled at the first frequency f₁ of 50 Hz when the first frequency f₁ is identical to the system frequency of 50 Hz of the commercial power source 2.

Therefore, the voltages V1 at the point (c) that is of the series-connected portion of the first and second switch elements 10 and 11 becomes a first square-wave voltage string including a plurality of square-wave voltages that rise on a positive side as illustrated in Fig. 2B. A square-wave voltage level of the voltage V1 becomes the DC output voltage Vd1 of the photovoltaic panel 1.

In the second chopper circuit 6, the third and fourth switch elements 12 and 13 are alternately ON/OFF-controlled at the second frequency f₂ of 100 Hz that is double the first frequency f₁.

Therefore, as illustrated in Fig. 2C, the voltage V2 at the point (e) that is of the series-connected portion of the third and fourth switch elements 12 and 13 becomes a second square-wave voltage string including the plurality of square-wave voltages that fall on a negative side based on the point (c) that is of the series-connected portion of the first and second switch elements 10 and 11.

A square-wave voltage level of the voltage V2 is controlled so as to become a half of the DC output voltage Vd1.

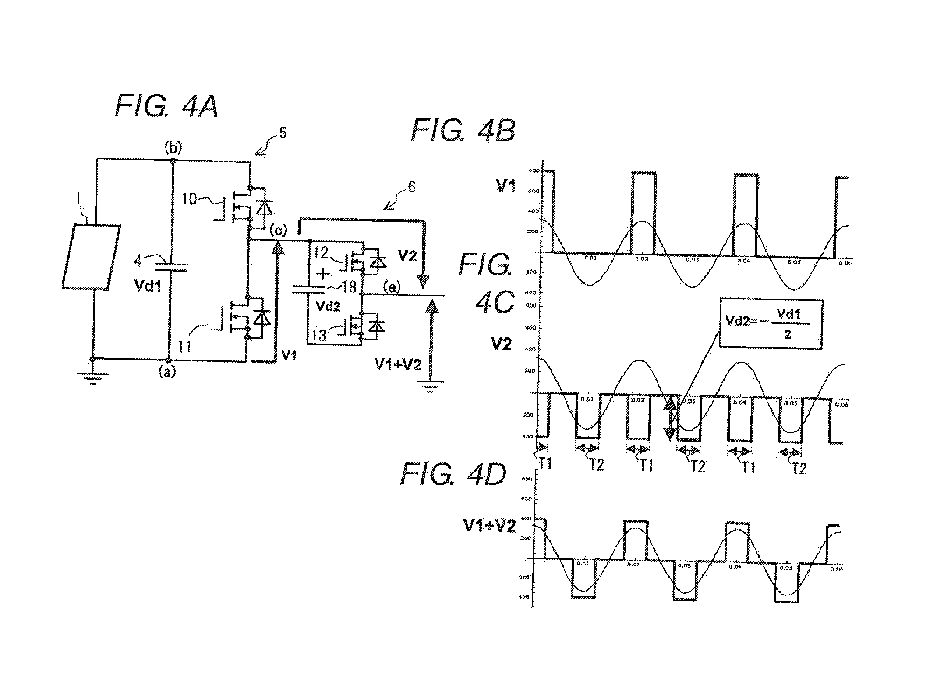

As illustrated in Fig. 4D (described later), the voltage V2 at the point (e) that is of the series-connected portion of the third and fourth switch elements 12 and 13 of the second chopper circuit 6 becomes a voltage V1 + V2 that is the sum of the voltage V1 between the points (a) and (c) and the voltage V2 between the points (c) and (e) based on the point (a) that is of the ground, that is, the first reference potential. The voltage V1 + V2 has a stepwise waveform corresponding to the sine wave that alternately changes positive and negative. The stepwise voltage V1 + V2 alternately changes positive and negative in synchronization with the command value V* of the sine-wave target voltage illustrated by the thin solid line of Fig.4D.

In the third chopper circuit 7, the fifth and sixth switch elements 14 and 15 are alternately ON/OFF-controlled at the third frequency f₃ of 150 Hz that is triple the first frequency f₁ so as to compensate a difference voltage between the voltage V1 + V2 having the stepwise waveform and the command value V* of the sine-wave target voltage, and the seventh and eighth switch elements 16 and 17 are PWM-controlled at the frequency f₄ of 18 kHz.

Therefore, as illustrated in Fig. 2D, the voltages V3 at the point (h) that is of the series-connected portion of the seventh and eighth switch elements 16 and 17 of the third chopper circuit 7 illustrated in Fig. 2A corresponds to the difference voltage between the voltage V1 + V2 having the stepwise waveform and the command value V* of the sine-wave target voltage when being illustrated by an average value of PWM based on the point (e) that is of the series-connected portion of the fifth and sixth switch elements 14 and 15.

Accordingly, the voltage V3 at the point (h) that is of the series-connected portion of the seventh and eighth switch elements 16 and 17 of the third chopper circuit 7 becomes a sine-wave voltage corresponding to the command value V* of the sine-wave target voltage synchronized with the commercial power source 2 based on the first reference potential at the point (a) that is of the ground.

Then operation principle of the first to third chopper circuits 5 to 7 will be described in detail below.

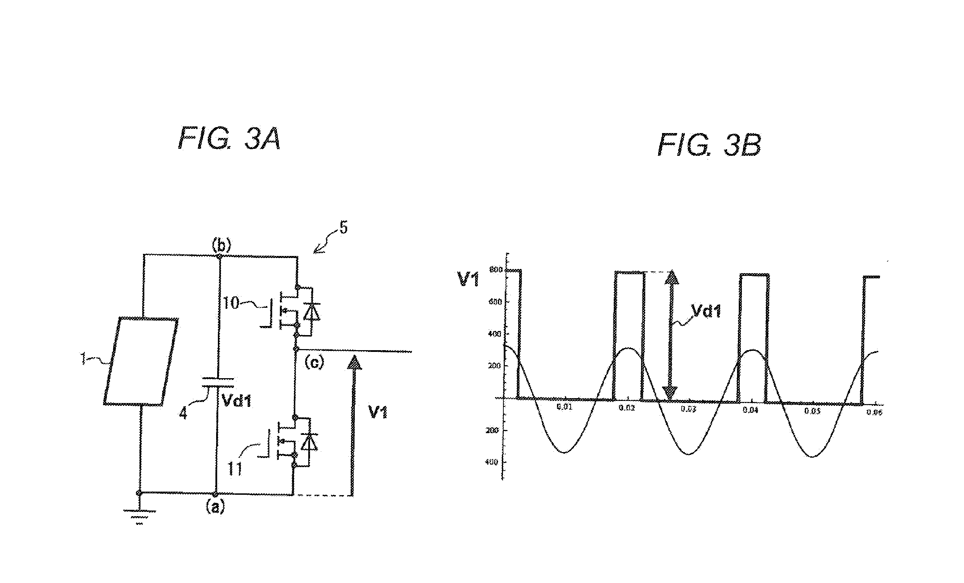

Figs. 3A and 3B are views for explaining the operation principle of the first chopper circuit 5, Fig. 3A illustrates the photovoltaic panel 1, the first capacitor 4, and the first chopper circuit 5, and Fig. 3B illustrates the voltage V1 between the points (a) and (c). Particularly, in Fig. 3B, the command value V* of the sine-wave target voltage is illustrated by the thin solid line.

The DC output voltage Vd1 of the photovoltaic panel 1 emerges at the point (b) on the positive electrode side of the photovoltaic panel 1. The DC output voltage Vd1 is smoothed by the first capacitor 4 when the potential at the point (a) that is of the ground is set to the first reference potential.

In the first chopper circuit 5, the DC output voltage Vd1 is chopped by the first and second switch elements 10 and 11 that are alternately ON/OFF-controlled at the first frequency f₁ of 50 Hz.

When the first switch element 10 is turned on while the second switch element 11 is turned off, the charge voltage Vd1 at the first capacitor 4 that is the voltage at the point (b) emerges at the point (c) that is of the series-connected portion of the first and second switch element 10 and 11 of the first chopper circuit 5.

When the first switch element 10 is turned off while the second switch element 11 is turned on, the ground voltage at the point (a) emerges at the point (c) that is of the series-connected portion of the first and second switch elements 10 and 11 of the first chopper circuit 5.

Accordingly, as described above, the voltage V1 at the point (c) that is of the series-connected portion of the first and second switch elements 10 and 11 becomes the first square-wave voltage string including the plurality of square-wave voltage that rise on the positive side when the ground potential is set to the first reference potential as illustrated in Fig. 3B. The voltage V1 is the voltage at the point (c) that is of the series-connected portion of the first and second switch elements 10 and 11 based on the point (a), and the square-wave voltage level becomes the DC output voltage Vd1 of the photovoltaic panel 1, for example, 800 V.

In the first chopper circuit 5, the effective power can be output because the square-wave voltage string whose phase is matched with that of the system voltage is produced.

Figs. 4A to 4D are views for explaining the operation principle of the second chopper circuit 6, Fig. 4A illustrates the first chopper circuit 5 and the second chopper circuit 6, Fig. 4B illustrates the voltage V1, Fig. 4C illustrates the voltages V2, and Fig. 4D illustrates the voltage V1 + V2. In Figs. 4B to 4D, the command value V* of the sine-wave target voltage is also illustrated by the thin solid line.

In the second chopper circuit 6, the voltage V1 at the point (c) illustrated in Fig. 4B is chopped by the third and fourth switch elements 12 and 13 that are alternately ON/OFF-controlled at the second frequency f₂ of 100 Hz.

When the third switch element 12 is turned on while the fourth switch element 13 is turned off, the potential at the point (e) that is of the series-connected portion of the third and fourth switch elements 12 and 13 becomes the same potential as the point (c) that is of the series-connected portion of the first and second switch elements 10 and 11 of the first chopper circuit 5. When the third switch element 12 is turned off while the fourth switch element 13 is turned on, the potential at the point (e) that is of the series-connected portion of the third and fourth switch elements 12 and 13 becomes more negative than the potential at the point (c). Accordingly, as described above, the voltage V2 at the point (e) that is of the series-connected portion of the third and fourth switch elements 12 and 13 becomes the second square-wave voltage string including the plurality of square-wave voltages that fall on the negative side when the potential at the point (c) that is of the series-connected portion of the first and second switch elements 10 and 11 is set to the second reference potential as illustrated in Fig. 4C.

When the first switch element 10 of the first chopper circuit 5 is turned on while the second switch element 11 is turned off, the third switch element 12 of the second chopper circuit 6 is turned off while the fourth switch element 13 is turned off, thereby charging the second capacitor 18. When the first switch element 10 of the first chopper circuit 5 is turned off while the second switch element 11 is turned on, the third switch element 12 of the second chopper circuit 6 is turned off while the fourth switch element 13 is turned off, thereby discharging the charge accumulated in the second capacitor 18 through the turned-on switch elements 11 and 13. As illustrated in Fig. 4C, in the second capacitor 18 the charge during a charge period T1 and the discharge during a discharge period T2 are alternately repeated to produce the square-wave voltage that falls on the negative side based on the second reference potential at the point (c). The square-wave voltage level Vd2 becomes a half (Vd2 = -Vd1/2) of the DC output voltage Vd1 of the photovoltaic panel 1, for example, 400 V.

The voltage V2 is a voltage at the point (e) that is of the series-connected portion of the third and fourth switch element 12 and 13 based on the point (c) that is of the series-connected portion of the first and second switch element 10 and 11.

Accordingly, in the second chopper circuit 6, the voltage V1 + V2 that is the sum of the voltage V1 between the points (a) and (c) illustrated in Fig. 4B and the voltage V2 between the points (c) and (e) illustrated in Fig. 4C emerges at the point (e) when the potential at the point (a) that is of the ground is set to the first reference potential. The voltage V1 + V2 has the stepwise waveform that alternately changes positive and negative according to the change of the command value V* of the sine-wave target voltage illustrated in Fig. 4D.

In the second chopper circuit 6, even-numbered-order high-harmonics can be removed because the square-wave voltage string that falls on the negative side is produced, and the effective power becomes zero in principle because the charge and discharge are repeated at the equal power.

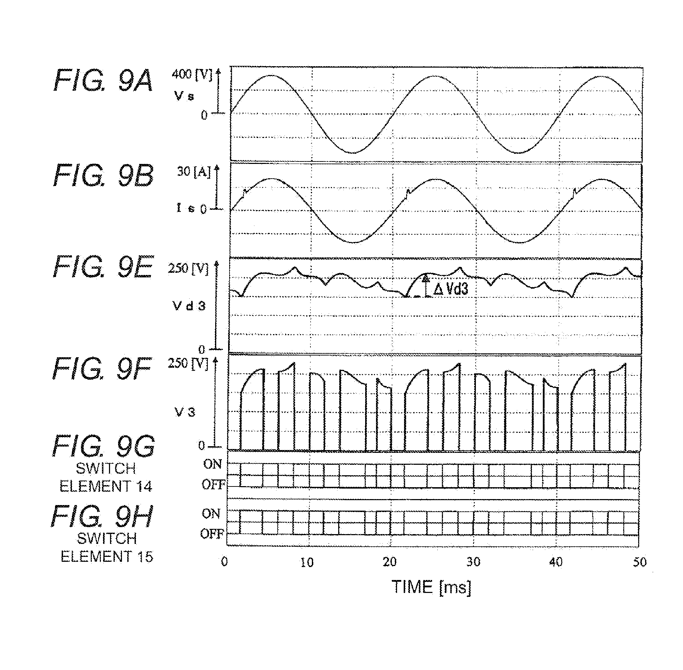

The system current is of Fig. 9B (described later) is passed through the second capacitor 18, thereby performing the charge and the discharge. When the system current is of Fig. 9B is positive, the second capacitor 18 is charged by the sine-wave current during the period T1 of Fig. 4C. Therefore, the voltage V2 is gradually decreased during the period T1 in the actual operation. Similarly, when the system current is of Fig. 9B is negative, the second capacitor 18 is discharged by the sine-wave current during the period T2 of Fig. 4C. Therefore, the voltage V2 is gradually increased during the period T2 in the actual operation.

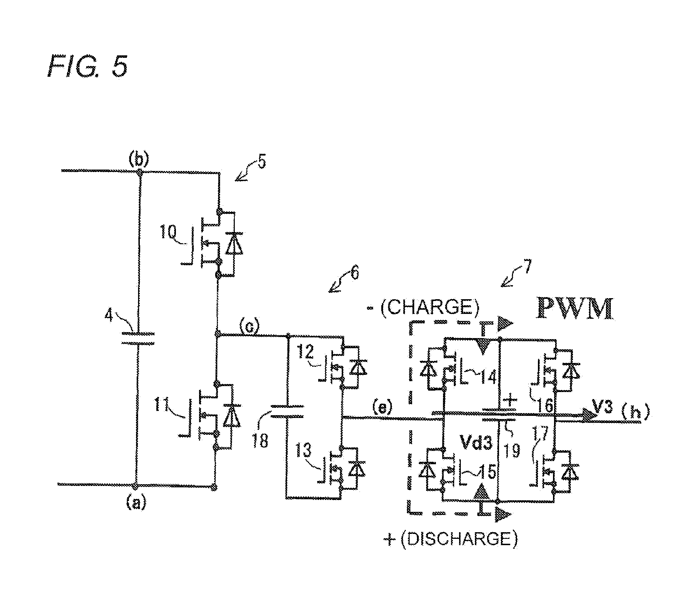

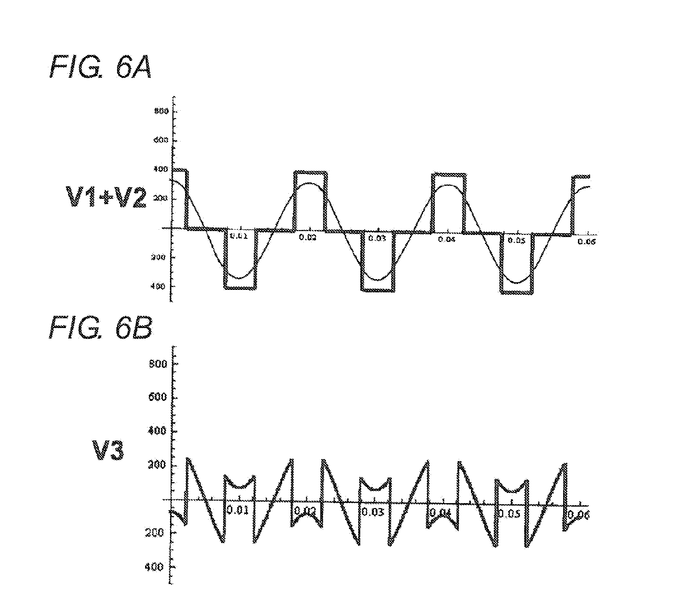

Fig. 5 is a view for explaining the operation principle of the third chopper circuit 7, Fig. 6A illustrates the voltage V1 + V2 having the stepwise waveform, and Fig. 6B illustrates the voltage V3 at the point (h) that is of the series-connected portion of the seventh and eighth switch elements 16 and 17 as the average value of PWM based on the point (e) that is of the series-connected portion of the fifth and sixth switch elements 14 and 15. In Fig. 6A, the command value V* of the sine-wave target voltage is also illustrated by the thin solid line.

The fifth and sixth switch elements 14 and 15 are ON/OFF-controlled in timing corresponding to the positive and negative of the difference voltage between the voltage V1 + V2 having the stepwise waveform at the point (e) illustrated in Fig. 6A and the command value V* of the sine-wave target voltage, As a result, the third capacitor 19 is charged and discharged by the volatge V1 + V2 at the time the fifth and sixth switch elements 34 and 15 are ON/OFF-controlled.

In other words, when a relational expression of voltage \/1 + V2 > command value V* of sine-wave target voltage holds, the difference voltage is positive, the control is performed such that the fifth switch element 14 is turned on while the sixth switch element 15 is turned off, whereby the third capacitor 19 is charged by the voltage V1 + V2.

On the other hand, when a relational expression of voltage V1 + V2 < command value V* of sine-wave target voyage holds, the difference voltage is negative, the control is performed such that the fifth switch element 14 is turned off while the sixth switch element 15 is turned on, thereby discharging the third capacitor 19.

A period of a magnitude relation of the difference voltage is the third frequency f₃ of 150 Hz, and therefore the fifth and sixth switch elements 14 and 15 are alternately ON/OFF-controller at the third frequency f₃.

In the third chopper circuit 7, the seventh and eighth switch elements 16 and 17 are PWM-controlled at the fourth frequency f₄ of 18 kHz that is hundreds times the first frequency f₁ with a duty that corrects the difference voltage between the voltage V1 + V2 and the command value V* of the sine-wave target voltage. Therefore, as illustrated in Fig. 6B, the voltage V3 corresponding to the difference voltage between the voltage V1 + V2 having the stepwise waveform and the command value V* of the sine-wave target voltage emerges at the point (h) that is of the series-connected portion of the seventh and eighth switch elements 16 and 17. The voltage V3 indicates the average value of the PWM, and the voltage V3 is a voltage at the point (h) that is of the series-connected portion of the seventh and eighth switch elements 16 and 17 based on the point (e) that is of the series-connected portion of the fifth and sixth switch elements 14 and 15.

Accordingly, in the third chopper circuit 7, the command value V* of the sine-wave target voltage whose phase is identical to that of the change in power system frequency illustrated by the thin solid line of Fig. 6A at the point (h) that is of the series-connected portion of the seventh and eighth switch elements 16 and 17 based on the first reference potential at the point (a) that is of the ground. The command value V* of the sine-wave target voltage is the sum of the voltage V1 + V2 between the points (a) and (e) illustrated in Fig. 6A and the voltage V3 between the points (e) and (h) illustrated in Fig. 6B.

In the third chopper circuit 7, the difference with the sine-wave voltage is eliminated while the chopping is performed at the frequency that is triple the system frequency, so that at least three-order high-harmonic can be suppressed.

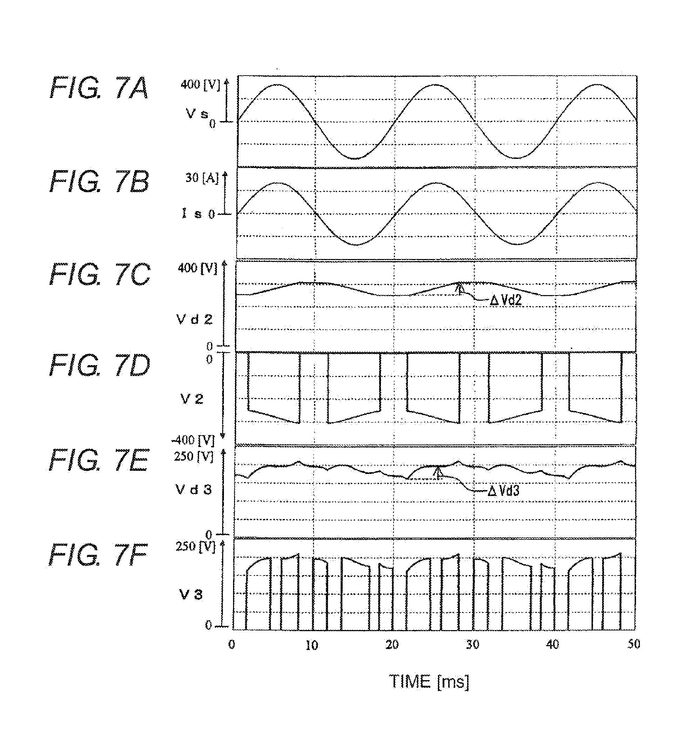

A system that detects the capacity leakages of the second and third capacitors 18 and 19 will be described below with reference to Fig. 7 to Fig. 15. Each of the second and third capacitors 18 and 19 includes a plurality of capacitors that are connected in parallel. When the capacity leakage is generated in one of the plurality of capacitors constituting each of the second and third capacitors 18 and 19, other capacitors become overload states, heat is generated by an internal resistances of the capacitors, and a ripple is generated at the output-side current is, which results in a problem in that the output power cannot be transmitted onto the side of the commercial power source 2 of the system,

In such a case, conventionally, the capacity leakages of the second and third capacitors 18 and 19 are monitored, and it is necessary to stop the running of the system to change the second and third capacitors 18 and 19 to the new components when the capacity leakages are generated. On the other hand, in the embodiment, even if the capacity leakages are generated in second and third capacitors 18 and 19, only the running of the system is not stopped, but the continuity of the running can be performed to extend the continuity of the system, and the running of the system is stopped at the time the capacity leakages of the second and third capacitors 18 and 19 progress,

The control circuit 9 measures the charge voltages Vd2 and Vd3 of the second and third capacitors 18 and 19, the output voltage Vs, and the output current is, and the control circuit 9 performs a following required control operation against the capacity leakages of the second and third capacitors 18 and 19 using the measured values as described later.

Figs. 7A to 7F illustrate a voltage waveform and a current waveform in each unit during a normal operation in which the capacity leakages are not generated in the second and third capacitors 18 and 19. Fig. 7A illustrates the output voltage Vs, Fig. 7B illustrates the output current is, Fig. 7C illustrates the charge voltage Vd2 at the second capacitor18, Fig. 7D illustrates the voltage V2 at the point (e) when the potential at the point (c) is set to the reference potential, Fig. 7E illustrates the charge voltage Vd3 at the third capacitor 19, and Fig. 7F illustrates the voltage V3 at the point (h) based on the point (e). In Figs. 7A to 7F, for the purpose of easy understanding, the values of the voltage and current are indicated by numeric values.

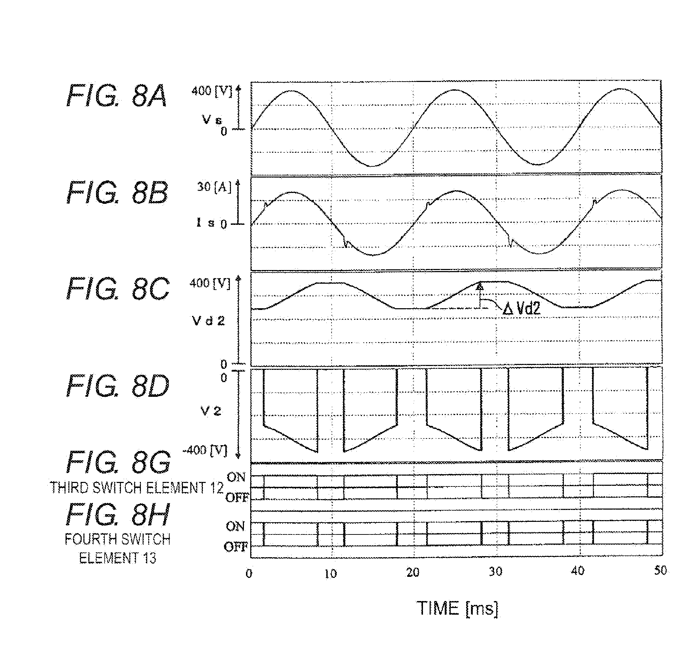

Figs. 8A to 8D, 8G, and 8H illustrate a voltage waveform and a current waveform in each unit when the capacity leakage is generated in the second capacitor 18 of the second and third capacitors 18 and 19. Fig. 8A to Fig. 8D correspond to Fig. 7A to Fig, 7D, respectively. Fig. 8G illustrates the turn-on and turn-off of the third switch element 12 of the second chopper circuit 6, and Fig, 8H illustrates the turn-on and turn-off of the fourth switch element 13 of the second chopper circuit 6. As illustrated in Fig. 7A and 7B and Figs. 8A and 8B, in the output current is and the output voltage Vs, a deformation is generated in the waveform of the output current is, As is clear from the comparison of Fig. 7C and Fig. 8C, the ripple exists in the charge voltage Vd2 of the second capacitor 18 illustrated in Fig. 8C.

Figs. 9A, 9B, 9E, 9F, 9G, and 9H illustrate a voltage waveform and a current waveform in each unit when the capacity and 9H illustrate a voltage waveform and a current waveform in each unit when the capacity leakage is generated in the third capacitor 19 of the second and third capacitors 18 and 19. Figs, 9A, 9B, 9E, and 9F correspond to Fig. 7A, 7B, 7E, and 7F, respectively. Fig. 9G illustrates the turn-on and turn-off of the fifth switch element 14 of the third chopper circuit 7, and Fig. 9H illustrates the turn-on and turn-off of the sixth switch element 15 of the third chopper circuit 7. As illustrate in Figs. 7A and 7B and Figs. 9A and 9B, in the output current is and the output voltage Vs, the deformation is generated in the waveform of the output current is, As is clear from the comparison of Fig. 7E and Fig. 9E, the ripple exists in the charge voltage Vd3 of the third capacitor 19 illustrated in Fig. 9E.

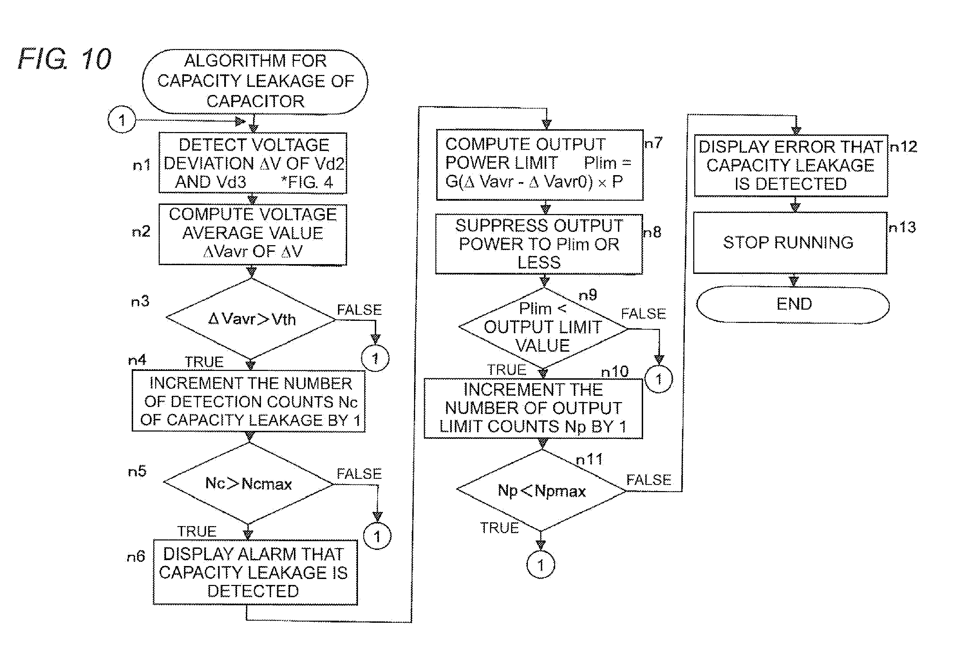

The method for detecting the capacity leakages of the second and third capacitors 18 and 19 will be described with reference to a flowchart of Fig. 10.

In step n1, voltage deviations ΔVd2 illustrated in Fig. 7C and Fig, 8C of the charge voltage Vd2 of the second capacitor 18 and voltage deviations ΔVd3 illustrated in Fig. 7E and Fig. 9E of the charge voltage Vd3 of the third capacitor 19 are detected. Each of the voltage deviations ΔVd2 and ΔVd3 are voltage difference between the maximum value and the minimum value of each of the charge voltages Vd2 and Vd3.

The voltage deviations ΔVd2 and ΔVd3 of the charge voltages Vd2 and Vd3 of each of the second and third capacitors 18 and 19 in the presence of the capacity leakage as illustrated in Fig. 8C and Fig. 9E is larger than the voltage deviations ΔVd2 and ΔVd3 of the charge voltages Vd2 and Vd3 of each of the second and third capacitors 18 and 19 in the absence of the capacity leakages as illustrated in Figs. 7C and 7E.

in step n2, an average value ΔVavr of the voltage deviations ΔVd2 and ΔVd3 is computed in order to prevent false detection of the capacity leakage. Because the voltage deviations ΔVd2 and ΔVd3 are instantaneous values, the voltage deviations ΔVd2 and ΔVd3 cannot rightly be measured due to an influence of a noise. Therefore, the average value ΔVavr is computed for a constant time to an extent in which the influences of the measurement errors of the voltage deviations ΔVd2 and ΔVd3 are not generated such that the average value ΔVavr can be used to determine the detection of the capacity leakage.

In step n3, a determination whether the average value ΔVavr is larger than a threshold Vth is made. When the average value ΔVavr is larger than the threshold Vth, the true determination is made, that is, the determination that the capacity leakage is generated is made, and the flow goes to step n4. When the average value ΔVavr is equal to or smaller than the threshold Vth, the false determination is made, and the flow returns to step n1. The threshold Vth can be fixed by the magnitude of the voltage ripple of each of the charge voltageVd2 of the second capacitors 18 and the charge voltage Vd3 of the third capacitor 19 in a range where the output current is can be controlled to the sine wave. For example, the threshold Vth can be fixed by a relationship between the voltage deviations ΔVd2 and ΔVd3 of the charge voltages Vd2 and Vd3 of each of the second and third capacitors 18 and 19 in the absence of the capacity leakage as illustrated in Figs. 7C and 7E and the voltage deviations ΔVd2 and ΔVd3 of the charge voltages Vd2 and Vd3 of each of the second and third capacitors 18 and 19 in the presence of the capacity leakage as illustrated in Fig. 8C and Fig. 9E.

In step n4, the number of detection counting times of the capacity leakage is incremented by 1. At this point, the number of counting times is used only in order to prevent the false detection of the capacity leakage.

In step n5, a determination whether the number of detection counting times Nc of the capacity leakage is large than the specified number of times Ncmax is made. The specified number of times Ncmax is only the number of times necessary to prevent the false detection of the capacity leakage, and the specified number of times Ncmax can experimentally be defined. When the number of detection counting times Nc of the capacity leakage is larger than the specified number of times Ncmax, the true determination is made, and flow goes to step n6. When the number of detection counting times Nc of the capacity leakage is equal to or smaller than the specified number of times Ncmax, the false determination is made, and the flow returns to step n1.

An alarm indicating that the capacity leakage is detected is displayed in step n6, and the flow goes to step n7. The display may be made in any way. The alarm may be issued by sound, or the alarm may be issued by an image,

In step n7, an output power limit Plim is computed. The output power limit Plim means a threshold of a restricted power when the output power is restricted in generating the capacity leakage such that the further power is not output. The output power limit Plim can be computed by the following equation. Plim = G ΔVavr-ΔVavr0) × P. Where G is a coefficient, ΔVavr is the average value of the voltage deviations ΔVd2 and ΔVd3, ΔVavr0 is the average value ΔVavr in the absence of the capacity leakage, and P is the output power.

In step n8, the output power is suppressed to the output power limit Plim or less. The reason the output power is suppressed to the output power limit Plim or less is that the output current is can reversely be flowed to the system side by solving the deformation of the output current is. That the deformation of the output current is is suppressed by suppressing the output power to the output power limit Plim or less is attributed to the fact that the charge or discharge amount of capacitor is decreased to decrease the change in voltage at the capacitor. When the change in voltage at the capacitor is decreased, because the state becomes similar to the state in which the capacitor capacity is increased, the deformation of the output current is is relaxed by suppressing the generated electricity.

In step n9, the determination whether the output power limit Plim is smaller than an output limit value is made. The output limit value is a threshold at which a malfunction caused by the capacity leakage is detected to stop the running of the system. When the output power limit Plim is smaller than the output limit value, the true determination is made, and the flow goes to step n10. When the output power limit Plim is equal to or larger than the output limit value, the false determination is made, and the flow returns to step n1.

In step n10, the number of output limit counts is incremented by 1. The number of output limit counts is used only in order to prevent the false detention.

In step n11, a determination whether the number of output limit counts Np is smaller than Npmax is made. When the number of output limit counts Np is smaller than Npmax, the true determination is made, and the flow goes to step n12. When the number of output limit counts Np is equal to or larger than Npmax, the false determination is made, and the flow returns to step n1.

An alarm indicating that the capacity leakage is detected is displayed in step n12, and the flow goes to step n13. The display may be made in any way. The alarm may be issued by sound, or the alarm may be issued by an image. At this point, in step n6, the running of the system is continued while the output power is suppressed due to the capacity leakage. On the other hand, the malfunction is detected due to the capacity leakage in step n12, and it is necessary to stop the running of the system in step n13. The running of the system is stopped when the maximum output power of the photovoltaic cell is decreased by the capacity leakage to eliminate the merit of the power use for a user, and the running of the system is inconveniently continued for a long time while the capacity leakage exists.

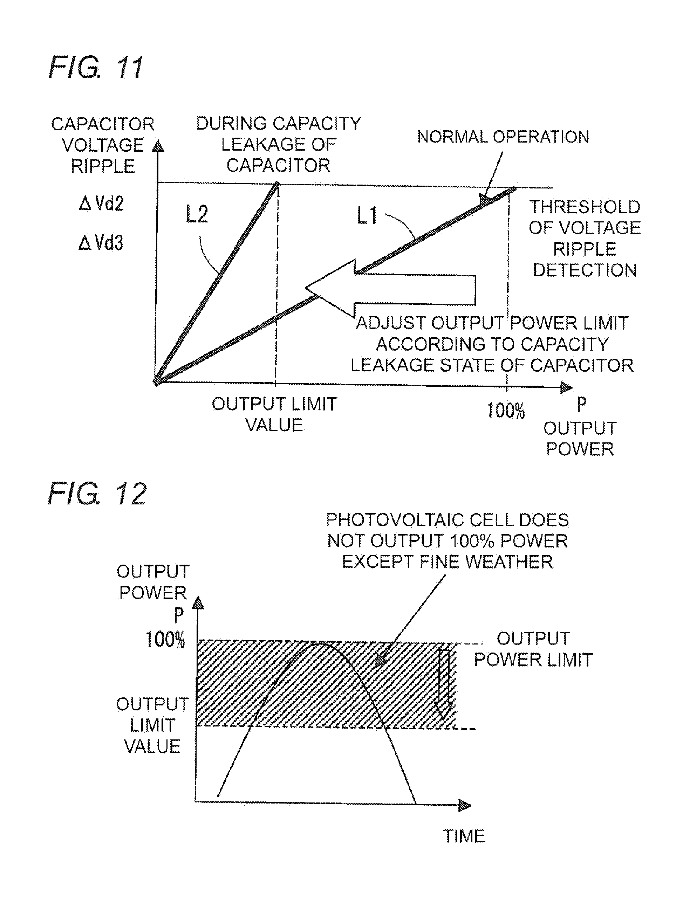

Referring to Fig. 11, a relationship between a horizontal axis of the output power (= output voltage Vs × output current is) and a vertical axis of the ripples of the charge voltages Vd2 and Vd3 of the second and third capacitors 18 and 19 will be described. When the capacity leakages are not generated in the second and third capacitors 18 and 19, the output power becomes 100% and the L1 indicates an output power-ripple characteristic. When the capacity leakages are generated in the second and third capacitors 18 and 19, the output power-ripple characteristic transitions to a characteristic L2 of the output limit value by the adjusting the output power limit as illustrated by an arrow.

The adjustment of the output power limit corresponds to steps n7 to n9 of the flowchart of Fig. 10.

A one-day output variation of the photovoltaic cell 1 will be described with reference to Fig. 12. in Fig. 12, the horizontal axis indicates a time, and the vertical axis indicates the output power of the photovoltaic panel 1. The photovoltaic panel 1 does not output the 100% power except fine weather. Therefore, the output power of the photovoltaic panel 1 is limited (restricted) from 100% to the output limit value as illustrated by a hatching of Fig. 12. The limit range is a region located between the 100% output power and the output limit value of the vertical axis.

The adjustment of the output power limit also corresponds to steps n7 to n9 of the flowchart of Fig. 10.

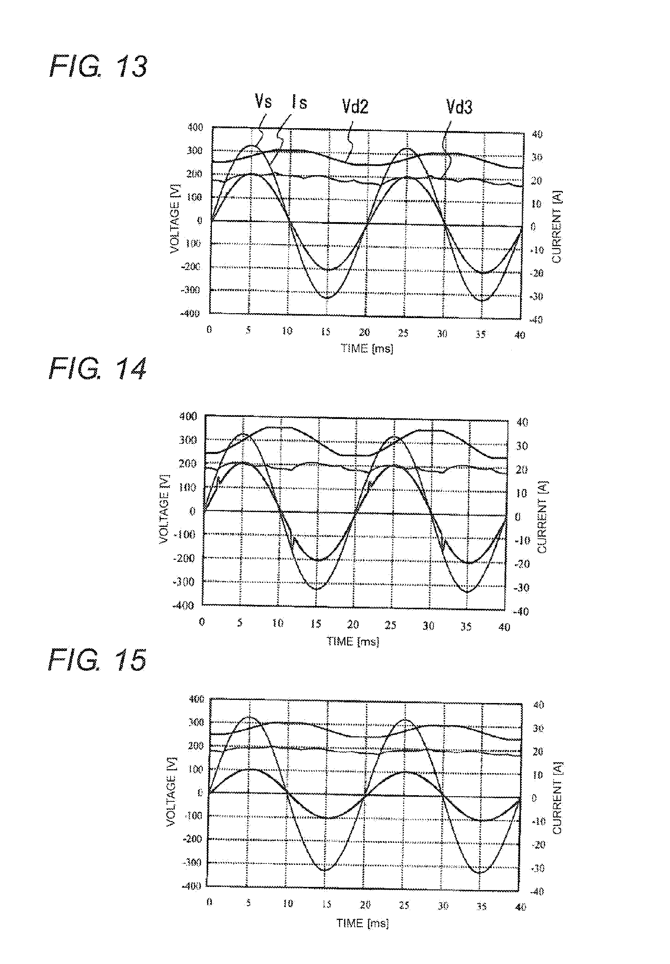

The output power suppression will be described with reference to Fig. 13 to 15. Fig, 13 illustrates the waveforms of the output current is, the output voltage Vs, the charge voltage Vd2 of the second capacitor 18, and the charge voltage Vd3 of the third capacitor 19 during the normal operation in which the capacity leakages are not generated in the second and third capacitors 18 and 19. Fig, 14 illustrates the waveforms of the output current Is, the output voltage Vs, the charge voltage Vd2 of the second capacitor 18. and the charge voltage Vd3 of the third capacitors 19 when the capacity leakages are generated in the second and third capacitors 18 and 19. Fig, 15 illustrates the waveforms of the output current Is, the output voltage Vs, the charge voltage Vd2 of the second capacitor 18, and the charge voltage Vd3 of the third capacitor 19 during the output power suppression (a half of the normal output power). As can be seen from Fig, 13 to Fig. 15, the deformation of the output current Is is improved by the output power suppression.

The output power suppression corresponds to steps n7 to n9 of the flowchart of Fig. 10.

As described above, the method for detecting the capacity leakage of the capacitor according to the embodiment includes the steps of: detecting that the capacity leakage exists based on the voltage deviation of the charge voltage between both ends of the capacitor (second capacitor 18 and third capacitor 19) of the detection target of the capacity leakage; suppressing the output power when the detected capacity leakage is a capacity leakage in which the running can be continued by the output power suppression; and stopping the running when the capacity leakage is a capacity leakage in which the running cannot be continued even if the output power is suppressed. Therefore, the stop of the running to change the capacitors is eliminated even if the capacity leakage is generated in the capacitor, and the running can be stopped when the capacity leakage progresses, so that the system having the excellent user-friendliness can be provided.

## Claims

1. A method for detecting a capacity leakage of at least one of a second capacitor (18) and a third capacitor (19) in a power conditioner (3) that performs power conversion of an output of a photovoltaic cell (1) to output an output power to a system side, the power conditioner including:
a first capacitor (4) that is connected in parallel to the photovoltaic cell,
a first chopper circuit (5) that includes at least first and second switch element (10, 11) connected in series, the first and second switch elements being connected in parallel to the first capacitor;
a second chopper circuit (6) that includes the second capacitor and at least third and fourth switch elements (12, 13) connected in series, the second capacitor being connected in parallel to the third and fourth switch elements, one end side of the parallel connection being connected to a common connection portion of the first and second switch elements; and
a third chopper circuit (7) that includes at least fifth and sixth switch elements (14, 15) connected in series, the third capacitor, and at least seventh and eighth switch elements (16, 17) connected in series, the fifth and sixth switch elements, the third capacitor, and the seventh and eighth switch elements being connected in parallel, one end side of the parallel connection of the fifth and sixth switch elements being connected to a common connection portion of the third and fourth switch elements,
the method being **characterized by** comprising the steps of:
detecting that the capacity leakage exists based on a voltage deviation of a charge voltage between both ends of the capacitor of a detection target of the capacity leakage; and
suppressing the output power when the detected capacity leakage is a capacity leakage in which running can be continued by suppression of the output power.

2. The method according to claim 1, **characterized by** further comprising
the step of stopping the running when the capacity leakage is a capacity leakage in which the running cannot be continued even if the output power is suppressed.

3. A power conditioner (3) that performs power conversion of an output of a photovoltaic cell (1) to output an output power to a system side, the power conditioner being **characterized by** comprising:
a first capacitor (4) that is connected in parallel to the photovoltaic cell;
a first chopper circuit (5) that includes at least first and second switch elements (10, 11) connected in series, the first and second switch elements being connected in parallel to the first capacitor;
a second chopper circuit (6) that includes a second capacitor (18) and at least third and fourth switch elements (12, 13) connected in series, the second capacitor being connected in parallel to the third and fourth switch elements, one end side of the parallel connection being connected to a common connection portion of the first and second switch elements; and
a third chopper circuit (7) that includes at least fifth and sixth switch elements (14, 15) connected in series, a third capacitor (19), and at least seventh and eighth switch elements (16, 17) connected in series, the fifth and sixth switch elements, the third capacitor, and the seventh and eighth switch elements being connected in parallel, one end side of the parallel connection of the fifth and sixth switch elements being connected to a common connection portion of the third and fourth switch elements, wherein
the capacity leakage of the second capacitor or third capacitor can be detected by the method according to claim 1 or 2.

4. A photovoltaic power system being **characterised by** comprising:
a thin-film photovoltaic cell (1); and
a power conditioner (3) that is disposed between the thin-film photovoltaic cell and a commercial power source (2), the power conditioner converting a DC power from the thin-fit photovoltaic cell into an AC power interconnected to a system of the commercial power source and outputting the AC power, wherein
the power conditioner according to claim 3 is used.
